# EUROPÄISCHE PATENTSCHRIFT

(11) **EP 0 755 581 B1**
(45) Veröffentlichungstag und Bekanntmachung des Hinweises auf die Patenterteilung: **14.01.1998**
(21) Anmeldenummer: 95933304.8
(22) Anmeldetag: 03.10.1995
(51) Int. Cl.: H02H 3/04, G01R 31/12

(54) **ÜBERSPANNUNGSSCHUTZEINRICHTUNG**
OVERVOLTAGE PROTECTION
DISPOSITIF DE PROTECTION CONTRE LES SURTENSIONS

(30) Priorität: 17.10.1994 DE 4436858
(43) Veröffentlichungstag der Anmeldung: 29.01.1997
(73) Patentinhaber: PILZ GmbH & CO., 73760 Ostfildern (DE)
(72) Erfinder: SCHWENKEL, Hans, Dieter, D-70192 Stuttgart (DE)
(74) Vertreter: Patentanwälte Rüger, Barthelt & Abel
(86) Internationale Anmeldenummer: DE9501357
(87) Internationale Veröffentlichungsnummer: WO9612332

(56) Entgegenhaltungen:
- US-A- 3 487 295
- PATENT ABSTRACTS OF JAPAN, vol. 940, no. 012 & JP-A-06 349386 (MITSUBISHI ELECTRIC CORP), 22. Dezember 1994

## Beschreibung

Bei jeder elektrischen Verbindung zwischen einem Ausgang und einem Eingang können durch Bauelementefehler oder durch Spannungsverschleppungen an dem betreffenden Ausgang oder dem Eingang Spannungen hervorgerufen werden, die höher sind als diejenige Spannung, die die betreffenden Bauelemente am Eingang oder am Ausgang verkraften können. Die Gefahr besteht insbesondere bei Steuerungen, wenn eine mit Halbleitern arbeitende Steuerung über verhältnismäßig lange Leitungen an ein zu steuerndes Gerät angeschlossen ist. Dabei kann die Gefährdung der Bauelemente nicht alleine dadurch ausgeschlossen werden, daß beispielsweise der Ausgang mit dem Eingang potentialfrei über einen Optokoppler verbunden ist. Auch hier können Spannungsverschleppungen durch Erdungsfehler oder Überspannungen durch elektrostatische Aufladungen die zulässige Spannung zwischen dem Eingang und dem Ausgang des Optokopplers überschreiten und ihn zerstören.

Um dies zu verhindern, werden Überspannungsschutzeinrichtungen verwendet, die Überspannungsspitzen kappen sollen, indem sie einen entsprechenden Strom nach Masse ableiten.

Allerdings ist es schwierig, über lange Zeit die Funktionsfähigkeit der Schutzeinrichtung zu gewährleisten, denn eine Prüfung setzt bisher eine entsprechende Überspannung voraus. Falls dann der Überspannungsableiter nicht funktioniert, hat die Prüfung die Zerstörung des betreffenden Eingangs oder Ausgangs der Steuerung zur Folge.

Ausgehend hiervon ist es Aufgabe der Erfindung, eine Überspannungsschutzeinrichtung zu schaffen, die ohne die Verwendung von Überspannungen auf Funktionsfähigkeit geprüft werden kann.

Diese Aufgabe wird erfindungsgemäß durch die Überspannungsschutzeinrichtung mit den Merkmalen des Anspruches 1 gelöst.

Weil die neue Überspannungsschutzeinrichtung wenigstens zwei Begrenzungsglieder enthält, die in Serie zwischen den Stromanschlüssen liegen, ist ein Testen der Begrenzungsglieder unterhalb der Begrenzungspannung der Gesamtanordnung möglich. Hierzu liegt zu der Kette der Begrenzungsglieder eine Kette aus Schalteinrichtungen parallel, wobei jeder Knotenpunkt der einen Kette mit dem Knotenpunkt der anderen Kette über einen Stromsensor verbunden ist. Wenn nun beim Testen bis auf eine Schalteinrichtung alle übrigen Schalteinrichtungen in den niederohmigen Zustand überführt werden, werden bis auf ein Begrenzungsglied alle übrigen Begrenzungsglieder praktisch kurzgeschlossen, so daß dasjenige Begrenzungsglied, das zu der nicht im niederohmigen Zustand befindlichen Schalteinrichtung parallelliegt, unmittelbar mit der an den Stromanschlüssen herrschenden Spannung beaufschlagt wird. Ein dann fließender Strom ist ein Maß für die Funktionsfähigkeit des betreffenden Begrenzungsgliedes.

Um diese Auswertung vornehmen zu können, kommen mehrere unterschiedliche Schaltungsanordnungen in Betracht. So kann beispielsweise die Kette aus Begrenzungsgliedern und die Kette aus Schalteinrichtungen über galvanische 0-Ohm Verbindungen parallelgeschaltet sein, d.h. zu jedem Begrenzungsglied liegt unmittelbar eine Schalteinrichtung parallel. Um hierbei während des Messens eine Stromüberlastung des Begrenzungsgliedes zu verhindern, enthält die Kette der Schalteinrichtungen wenigstens ein strombegrenzendes Element, das gegebenenfalls gleichzeitig als Stromsensor dient. Eine andere Möglichkeit besteht darin, in die Querverbindungen zwischen den beiden Serienschaltungen Stromsensoren vorzusehen.

Da im allgemeinen die Betriebsspannung und die maximal zulässige Überspannung verhältnismäßig weit auseinanderliegen, ist es vorteilhaft, wenn die Begrenzungsglieder aus mehreren in Serie geschalteten Begrenzungselementen bestehen. Außerdem kommt hierdurch im Falle des Ansprechens eine bessere Verteilung der Verlustleistungen zustande.

Als Begrenzungselemente kommen alle Bauelemente in Frage, die spannungsabhängig aus einem Zustand mit niedrigem Innenwiderstand in einen Zustand mit hohem Innenwiderstand umschalten bzw. umgekehrt. Beispiele hierfür sind Z-Dioden, Dioden oder Serienschaltungen daraus, Varistoren, VDR-Widerstände und Vergleichbares, beispielsweise auch eine Schaltung, bestehend aus einem bipolaren Transistor und einer Z-Diode, die zwischen Basis und Emitter des Transistors geschaltet ist. Die gesamte Anordnung verhält sich dann wiederum wie eine Z-Diode, jedoch mit höherer Verlustleistung.

Für die Schalteinrichtungen kommen ebenfalls mehrere unterschiedliche Bauelemente in Frage, so beispielsweise elektronische Halbleiterschalter, mechanische Schalter oder Relais, je nachdem, welcher Leistungsbereiche und Bedienkomfort abgedeckt werden soll.

Besonders zweckmäßig ist es, wenn der Überspannungsschutzeinrichtung Ablaufsteuerungen zugeordnet sind, so daß ein automatisches periodisches Testen möglich ist.

Im übrigen sind Weiterbildungen der Erfindung Gegenstand von Unteransprüchen.

In der Zeichnung sind Ausführungsbeispiele des Gegenstandes der Erfindung dargestellt. Es zeigen:
Fig. 1 ein Blockschaltbild zur Veranschaulichung des Einsatzes einer Überspannungsschutzeinrichtung,
Fig. 2 ein erstes Ausführungsbeispiel einer Überspannungsschutzeinrichtung mit Stromsensoren in Querverbindungen, und
Fig. 3 ein zweites Ausführungsbeispiel mit Stromsensoren in der Serienschaltung der Schalteinrichtungen.

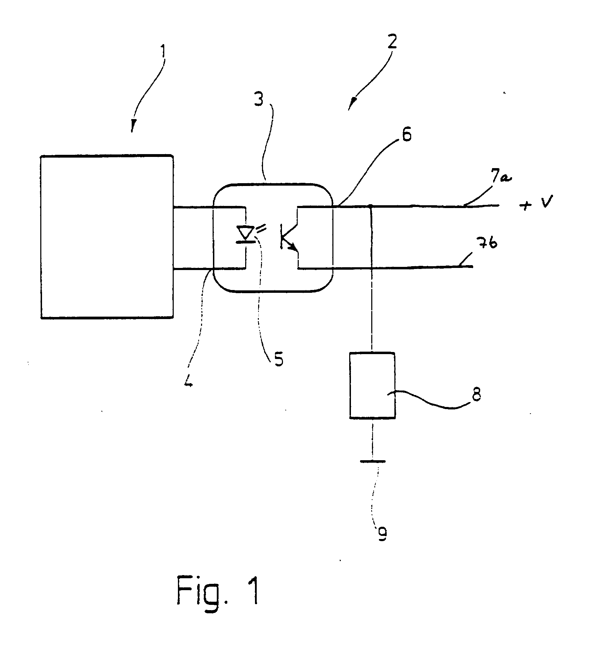

Fig. 1 zeigt eine elektronische Steuerung 1 mit einem potentialfreien Ausgang 2, der mit Hilfe eines Optokopplers 3 realisiert ist. Der Optokoppler 3 ist mit seinem Eingang 4 an eine nicht weiter veranschaulichte Treiberschaltung angeschlossen, wodurch die in dem Optokoppler 3 enthaltene Leuchtdiode 5 wahlweise mehr oder weniger zum Leuchten zu bringen ist, um an einem Ausgang 6 des Optokopplers 3 ein entsprechendes elektrisches Signal zu erhalten. Ausgangsseitig ist der Optokoppler 3 über eine Leitung 7a mit einer Spannungsquelle +V verbunden, während eine Leitung 7b zu einem Steuereingang einer nicht weiter gezeigten gesteuerten Last führt.

Innerhalb des Optokopplers besteht zwischen dem Eingang 4 und dem Ausgang 6 keinerlei galvanische Verbindung, so daß an sich keine Spannungsverschleppung zum Eingang 4 zustandekommen kann. Im ausgeschalteten Zustand d. h. wenn der bipolare Transistor in seinem Ausgang gesperrt ist können jedoch von außen kommende Störimpulse zu einer Spannung zwischen den Leitungen 7a und 7b führen, die den ausgeschalteten Ausgangstransistor des Optokopplers 2 spannungsmäßig überlasten. Es kann zu einem Spannungsdurchbruch zwischen Kollektor und Emitter kommen. Um derartige gefährliche Spannungen, die unter Umständen an dem Ausgang 6 auftreten können, zu verhindern, ist der Ausgang 6 des Optpkopplers 3 über einen Überspannungsableiter 8 zu einer Erde 9 hin verbunden.

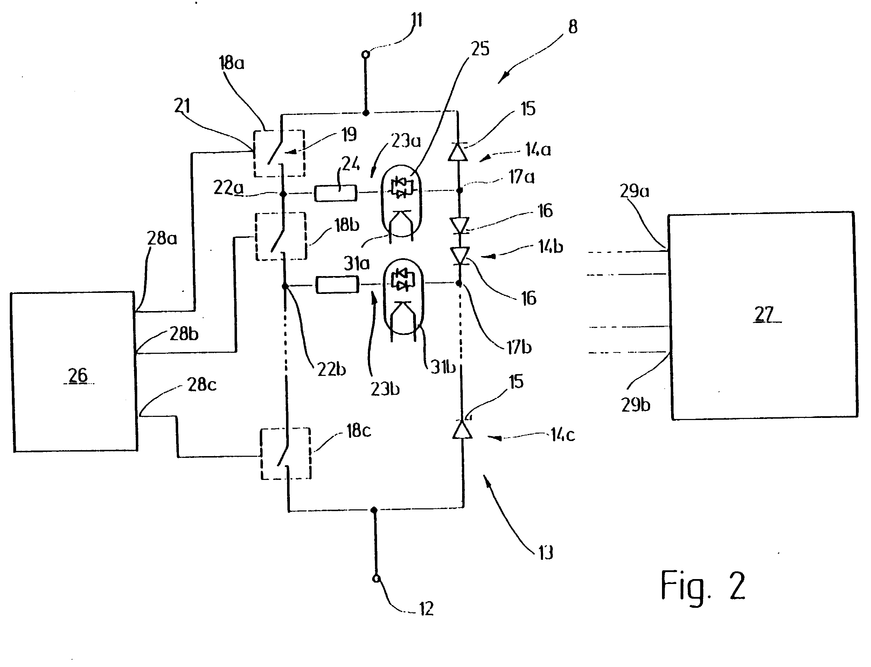

Der Aufbau des Überspannungsableiters 8 ist in Fig. 2 im einzelnen veranschaulicht. Er weist zwei Anschlußklemmen 11 und 12 auf, die mit der Schaltungsmasse 9 bzw. dem Ausgang 6 des Optpkopplers 3 zu verbinden sind. Zwischen den beiden Stromanschlüssen 11 und 12 liegt eine Serienschaltung 13 aus mehreren hintereinandergeschalteten Begrenzungsgliedern 14a...14c. Das Begrenzungsglied 14a ist durch eine Z-Diode 15 gebildet, ebenso wie das Begrenzungsglied 14c. In gleicher Weise können auch die dazwischenliegenden Begrenzungsglieder 14 aus jeweils einer Z-Diode bestehen, jedoch ist eine einzige Z-Diode keineswegs das einzige Element, um ein Begrenzungsglied 14 zu erzeugen. Jedes Begrenzungsglied 14 kann auch eine Serienschaltung aus mehreren Z-Dioden enthalten oder, wie dies beispielhaft bei dem Begrenzungsglied 14a gezeichnet ist, aus mehreren in Serien geschalteten einfachen Dioden 16 bestehen. Andere Bauelemente, die als Begrenzungsglieder 14 in Frage kommen, sind VDR-Widerstände oder auch Zweipolschaltungen mit Z-Diodencharakteristik oder Varistoren. In jedem Falle ist es günstig, wenn alle Begrenzungsglieder 14a...14c eines Überspannungsableiters 8 untereinander gleich sind und dieselben Kennwerte aufweisen.

Im einzelnen ist die Serienschaltung 13 derart aufgenbaut, daß mit dem Stromanschluß 11 die Kathode der Z-Diode 15 des Begrenzungsgliedes 14a verbunden ist. Die Anode dieser Z-Diode 15 liegt an einem Knoten 17a, an dem im Falle der Verwendung von ausschließlich Z-Dioden die Anode der Z-Diode des Begrenzungsgliedes 14b angeschlossen wäre. Die Anode von deren Z-Diode würde an einem Verbindungsknoten 17b anliegen usw. Die Z-Diode 15 des Begrenzungslgiedes 14c liegt schließlich anodenseitig an dem Stromanschluß 12.

Parallel zu der Serienschaltung 13 aus den Begrenzungsgliedern 14 liegt eine Kette aus mehreren elektronischen Schaltern 18a...18c, die jeweils eine Schaltstrecke 19 sowie einen Steuereingang 21 aufweisen und wobei die nachgestellten Buchstaben die Zugehörigkeit zu dem betreffenden Begrenzungsglied 14 versinnbildlichen sollen. Alle Schaltstrecken 19 sind in Serie geschaltet. Dies bedeutet,daß die Schaltstrecke 19 des elektronischen Schalters 18a einenends an dem Stromanschluß 11 liegt, während ihr anderes Ende an einem Verbindungsknoten 22a angeschaltet ist. An diesem Verbindungsknoten 22a treffen sich die Schaltstrecke 19 des elektronischen Schalters 18a und die Schaltstrecke 19 des elektronischen Schalters 18b. Letzterer ist anderenends an einen Verbindungsknoten 22b angeschlossen.

Der letzte elektronische Schalter 18c führt schließlich hin zu dem Stromanschluß 12.

Jeweils zwei einander entsprechende Verbindungsknoten 22 bzw. 17 der Serienschaltung aus den gesteuerten elektronischen Schaltern 18 und der Serienschaltung 13 sind über eine Querverbindung 23a bzw. 23b miteinander verschaltet. in dieser Querverbindung 23 liegt ein Stromsensor, bestehend aus einem ohmschen Widerstand 24 sowie einem bidirektionalen Optopkoppler 25, und zwar ist der Eingang des Optokopplers 25 mit dem Vorwiderstand 24 verbunden. Ein bidirektionaler Optokoppler ist in der Lage am seinem Eingang beide mögliche Strompolaritäten zur Erzeugung eines Ausgagssignals zu verarbeiten; er enthält hierzu zwei antiparallel geschaltete Leuchtdioden.

Wie zu erkennen ist, enthält der Überspannungsableiter 8 genauso viele elektronische Schalter 18 wie Begrenzungsglieder 14, während die Anzahl der Querverbindungen 23 um 1 (eins) kleiner ist.

Dem Überspannungsableiter 8 ist eine Steuerschaltung 26 sowie eine Auswerteschaltung 27 zugeordnet. Die Auswerteschaltung 26 weist mehrere Steuerausgänge 28 auf, von denen jeder mit einem entsprechenden Steuereingang 21 der elektronischen Schalter 18 verbunden ist. Die Auswerteschaltung 27 ist indessen mit mehreren Eingängen 29 versehen, von denen jeder mit einem Ausgang 31 eines der Optpkoppler 25 verbunden ist. Die in diesem Zusammenhang verwendeten kleinen lateinischen Buchstaben sollen wiederum die jeweilige Zuordnung symbolisieren.

Die Dimensionierung und die Funktionsweise des beschriebenen Überspannungsableiters 8 ist wie folgt:

Alle Begrenzungsglieder 14 haben dieselbe spannungs-abhängige Kennlinie, die dazu führt, daß sie unterhalb eines vorgegebenen Spannungsgrenzwertes einen verhältnismäßig großen differentiellen Innenwiderstand aufweisen, während sie beim Überschreiten dieses Grenzwertes einen verglichen mit dem differentiellen Innenwiderstand unterhalb des Grenzwertes kleinen differentiellen Innenwiderstand zeigen. Diese Grenzspannung wird im folgenden als Nennspannung bezeichnet.

Durch entsprechende Wahl der verwendeten Begrenzungselemente bzw. Wahl der Anzahl der Begrenzungselemente wird die Nennspannung jedes Begrenzungsgliedes 14 so eingestellt, daß sie kleiner ist als die kleinste im Normalbetrieb zu erwartende Spannung, die der Ausgang 6 des Optokopplers 3 gegenüber der Masse 9 hat.

Die Anzahl der erforderlichen Begrenzungsglieder 14 richtet sich dagegen nach der maximal zulässigen Überspannung, die im Betrieb zwischen dem Ausgang 6 und der Masse 9 auftreten darf, ehe der Überspannungsableiter 8 in Funktion treten soll. Wenn diese Überspannung beispielsweise viermal größer ist als die kleinste im Betrieb auftretende Spannung werden dementsprechend vier Begrenzungsglieder 14 benötigt.

Wenn der Überspannungsableiter 8 nicht auf seine Funktionsfähigkeit hin getestet wird, sind seitens der Steuerschaltung 26 sämtliche elektronischen Schalter 18 in den hochohmigen Schaltzustand überführt. Tritt nun eine Überspannung an dem Ausgang 6 auf, so wird die Überspannung von den Begrenzungselementen 14 nach Masse abgeleitet. Ohne Überspannung sind die Begrenzungselemente 14 hochohmig und nicht wirksam.

Um die Funktionsfähigkeit der einzelnen Begrenzungselemente 14 testen zu können, werden von der Steuerschaltung 26 nacheinander alle elektronischen Schalter 18 bis auf einen in den niederohmigen Zustand umgeschaltet. Zur Erläuterung der Funktionsweise sei angenommen, daß zunächst nur der elektronische Schalter 18a geöffnet bleibt, während alle übrigen geschlossen werden. Dadurch vermindert sich die Begrenzungsspannung des Überspannungsableiters 8 auf die Nennspannung des Begrenzungsgliedes 14a. Da dessen Nennspannung kleiner ist als die kleinste im Betrieb zu erwartende Spannung an dem Ausgang 6 gegenüber der Masse 9 wird das Begrenzungsglied 14a leitend und es beginnt ein Strom von dem Stromanschluß 11 durch den Querzweig 23a und von dort über die geschlossenen elektronischen Schalter 18b...18c zu dem Stromanschluß 12 zu fließen. Die Größe des Stroms wird mit Hilfe des Stromsensors, bestehend aus dem Vorwiderstand 24 und dem Optokoppler 25, gemessen, der seinen Meßwert an den betreffenden Eingang 29a der Auswerteschaltung 27 liefert.

Bei ordnungsgemäß arbeitendem Begrenzungsglied 14 fließt ein entpsrechender vorbekannter Strom durch die Querverbindung 23a. Wenn hingegen das Begrenzungsglied 14a einen Kurzschluß enthält oder aus anderen Gründen der Spannungsnennwert abgesunken ist, fließt in der Querverbindung 23a ein höherer Strom, wodurch auf einen Fehler zurückgeschlossen werden kann. Falls gar kein Strom in der Querverbindung 23a fließt, ist das Begrenzungsglied 14a ausgefallen.

Im nächsten Schritt wird zum Testen des Überspannungsableiters 8 der Schalter 18b geöffnet und der Schalter 18a geschlossen. Jetzt kann der Strom von dem Stromanschluß 11 über den geschlossenen elektronischen Schalter 18a, die Querverbindung 23a zu dem Begrenzungsglied 14b und von dort über die Querverbindung 23b zu der restlichen Kaskade aus elektronischen Schaltern 18 zu dem Stromanschluß 12 fließen. Der nun in dem Stromsensor der Querverbindung 23a oder 23b gemessene Strom ist wiederum ein kennzeichnendes Merkmal dafür, daß das Begrenzungsglied 14b ordnungsgemäß arbeiten kann oder ausgefallen ist.

Sinngemäß werden in gleicher Weise nacheinander alle Begrenzungsglieder 14 getestet und die erhaltenen Stromwerte werden durch die Auswerteschaltung 27 entsprechend analysiert.

Bei dem neuen Überspannungsableiter 8 ist es ersichtlicherweise notwendig, daß er aus einzelnen Begrenzungsgliedern aufgebaut ist, damit er im Normalbetrieb ohne die Verwendung von gefährlichen Überspannungen getestet werden kann. Im Testfall werden bis auf das zu testende Begrenzungsglied alle übrigen Begrenzungsglieder im wesentlichen durch die parallelgeschalteten elektronischen Schalter geshuntet oder kurzgeschlossen.

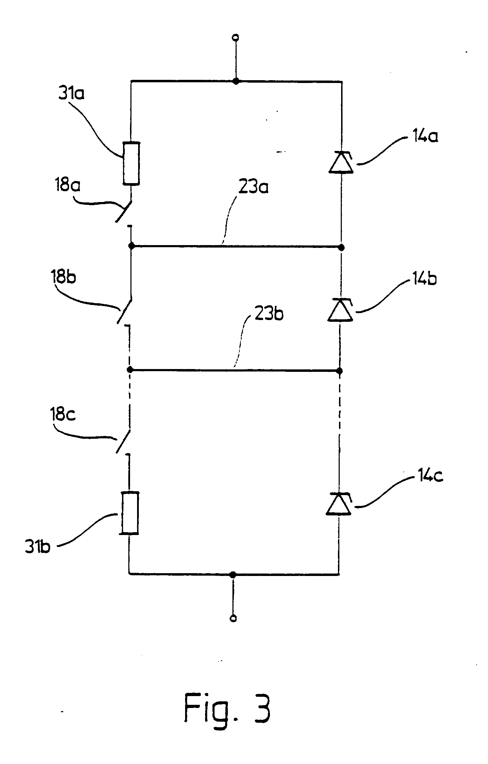

Fig. 3 zeigt eine abgewandelte Ausführungsform des Überspannungsableiters 8, wobei bereits beschriebene Bauteile mit denselben Bezugszeichen versehen sind.

Der wesentliche Unterschied zu der Ausführungsform nach Fig. 2 besteht darin, daß die Querverbindungen 23 als galvanische Kurzschlußverbindungen ausgeführt sind und lediglich an dem oberen und dem unteren Ende der Kette aus den elektronischen Schaltern 18 jeweils Strombegrenzungselemente oder Stromsensoren 31a und 31 enthalten sind.

Die Dimensionierung des Überspannungsableiters nach nach Fig. 3 erfolgt in der gleichen Weise wie bei dem Ausführungsbeispiel nach Fig. 2. Die Begrenzungswirkung im Normalbetrieb ist ebenfalls gleich.

Zum Überprüfen der einzelnen Begrenzungsglieder 14 werden wiederum, wie voher, bis auf einen elektronischen Schalter 18 alle übrigen elektronischen Schalter 18 niederohmig geschaltet, so daß während dieser Zeit die Spannung an dem Ausgang 6 nur an jenem Begrenzungsglied 14 anliegt, dessen zugeordneter elektronischer Schalter 18 geöffnet ist. Dementsprechend fließen mehr oder weniger große Ströme über die beiden Vorwiderstände 31a und 31b und der dort auftretende Spannungsabfall läßt einen Rückschluß auf die Funktionsfähigkeit des betreffenden Begrenzungsgliedes 14 zu.

Die Messung kann mit Ausnahme der nachfolgenden Einschränkung entweder an dem Widerstand 31a oder dem Widerstand 31b vorgenommen werden. Keine Wahl des Meßwiderstandes 31 oder 31b besteht allerdings dann, wenn der unmittelbar an den betreffenden Widerstand 31a oder 31b angeschlossene elektronische Schalter 18 geöffnet ist. Die Testmessung muß dann an jenem Widerstand 31 oder 31b erfolgen, dessen zugehöriger elektronischer Schalter 18 geschlossen ist.

## Patentansprüche

1. Überspannungsschutzeinrichtung
mit zwei Stromanschlüssen (11,12),
mit wenigstens zwei in Serie geschalteten Begrenzungsgliedern (14), deren Durchlaßwiderstand unterhalb einer vorbestimmten Durchlaßspannung einen hohen Wert und oberhalb der Durchlaßspannung einen niedrigen Wert aufweist, wobei die Serienschaltung (13) aus den Begrenzungsgliedern (14) zwischen den Stromanschlüssen (11,12) liegt und die Summe der Durchlaßspannungen der wenigstens zwei Begrenzungsglieder (14) eine maximal zulässige Spannung zwischen den Stromanschlüssen (11,12) definiert, während die Durchlaßspannung jedes einzelnen Begrenzungsglieds (14) kleiner als eine minimal zu erwartende und von null verschieden Eingangsspannung an den Stromanschlüssen (11, 12) ist, und
mit einer zwischen den Stromanschlüssen (11,12) liegenden Serienschaltung aus Schalteinrichtungen (18), die zahlenmäßig mit der Anzahl der Begrenzungsglieder (14) übereinstimmt und von denen jede wahlweise einen hochohmigen oder einen niederohmigen Zustand einehmen kann, wobei jeder Verbindungsknoten (22) zwischen benachbarten Schalteinrichtungen (18) an einen zugehörigen Verbindungsknoten (17) zwischen benachbarten Begrenzungsgliedern (14) über eine elektrische Querverbindung (23) angeschlossen ist.

2. Überspannungsschutzeinrichtung nach Anspruch 1, dadurch gekennzeichnet, daß jede Querverbindung (23) einen Stromsensor (24,25) enthält.

3. Überspannungsschutzeinrichtung nach Anspruch 1, dadurch gekennzeichnet, daß die Anzahl der Querverbindungen (23) um 1 kleiner ist als die Anzahl der Begrenzungsglieder (14).

4. Überspannungsschutzeinrichtung nach Anspruch 1, dadurch gekennzeichnet, daß jede Querverbindung (23) eine galvanische 0-Ohm Verbindung ist und daß die Serienschaltung der Schalteinrichtungen (18) wenigstens eine Strombegrenzungseinrichtung (31) aufweist.

5. Überspannungsschutzeinrichtung nach Anspruch 6, dadurch gekennzeichnet, daß eine Strombegrenzungseinrichtung (31a) an einem Ende der Serienschaltung der Schalteinrichtungen (18) und eine weitere Strombegrenzungseinrichtung (31b) an einem an dem anderen Ende der Serienschaltung der Schalteinrichtungen (18) enthalten ist.

6. Überspannungsschutzeinrichtung nach Anspruch 4, dadurch gekennzeichnet, daß die Strombegrenzungseinrichtung (31) einen Stromsensor aufweist.

7. Überspannungsschutzeinrichtung nach Anspruch 2 oder 6, dadurch gekennzeichnet, daß der Stromsensor einen Widerstand (24,31) vorzugsweise einen ohmschen Widerstand aufweist.

8. Überspannungsschutzeinrichtung nach Anspruch 2 oder 6, dadurch gekennzeichnet, daß der Stromsensor einen Optokoppler (25) aufweist

9. Überspannungsschutzeinrichtung nach Anspruch 1, dadurch gekennzeichnet, daß jedes Begrenzungsglied (14) entweder von einem einzigen Begrenzungselement (16) oder einer Serienschaltung von wenigstens zwei Begrenzungselementen (16) gebildet ist.

10. Überspannungsschutzeinrichtung nach Anspruch 8, dadurch gekennzeichnet, daß das Begrenzungselement (16) eine Z-Diode, eine Diode, ein Varistor, ein VDR-Widerstand oder ein anderes Bauelement oder eine zu einem Zweipol zusammengeschaltete Anordnung mit der entsprechenden Kennlinie ist.

11. Überspannungsschutzeinrichtung nach Anspruch 1, dadurch gekennzeichnet, daß die Schalteinrichtung (18) ein elektronischer Schalter mit Steuereingang (21) ist.

12. Überspannungsschutzeinrichtung nach Anspruch 10, dadurch gekennzeichnet, daß die Schalteinrichtung (18) ein elektromechanischer Schalter mit Steuereingang ist.

13. Überspannungsschutzeinrichtung nach Anspruch 11, dadurch gekennzeichnet, daß der elektromechanische Schalter ein Relais ist.

14. Überspannungsschutzeinrichtung nach Anspruch 1, dadurch gekennzeichnet, daß ihr eine Steuerschaltung (26) zugeordnet ist, um nacheinander die Schalteinrichtungen (18) zu betätigen.

15. Überspannungsschutzeinrichtung nach Anspruch 1, dadurch gekennzeichnet, daß ihr eine Auswerteschaltung (27) zugeordnet ist, um nacheinander die von den Stromsensoren (24,25,31) abgegebenen Werte und/oder die an den Begrenzungsgliedern (14) anliegenden Spannungen auszuwerten.

## Claims

1. Overvoltage suppressor comprising
two electrical connections (11,12),
at least two series-connected limiting members (14), the on-state resistance of which has a high value below a predetermined threshold voltage and a low value above the threshold voltage, wherein the series connection (13) comprising the limiting members (14) lies between the current connections (11, 12) and the sum of the threshold voltages of the at least two limiting members (14) defines a maximum permissible voltage between the electrical connections (11, 12), whereas the threshold voltage of each individual limiting member (14) is lower than a minimum predetermined input voltage which is different from zero at the electrical connections (11, 12), and
a series circuit comprising switch devices (18) lying between the electrical connections (11, 12) and which in number equal the number of limiting members (14) and of them each may selectively exhibit a high-impedance or a low-impedance state, wherein each connection node (22) between neighbouring switch devices (18) is connected to an associated connection node (17) between neighbouring limiting members (14) via an electrical transverse connection (23).

2. Overvoltage suppressor according to claim 1, characterised in that each transverse connection (23) contains a current sensor (24, 25).

3. Overvoltage suppressor according to claim 1, characterised in that the number of transverse connections (23) is smaller by 1 than the number of limiting members (14).

4. Overvoltage suppressor according to claim 1, characterised in that each transverse connection (23) is a galvanic 0-ohm connection, and in that the series connection of switch devices (18) has at least one current limiting device (31).

5. Overvoltage suppressor according to claim 9, characterised in that a current limiting device (31a) is provided at one end of the series circuit of switch devices (18) and a further current limiting device (31b) is provided at the other end of the series circuit of switch devices (16).

6. Overvoltage suppressor according to claim 4, characterised in that the current limiting device (31) comprises a current sensor.

7. Overvoltage suppressor according to claim 2 or 6, characterised in that the current sensor comprises a resistor (24, 31), preferably an ohmic resistor.

8. Overvoltage suppressor according to claim 2 or 6, characterised in that the current sensor comprises an optocoupler (25).

9. Overvoltage suppressor according to claim 1, characterised in that each limiting member (14) is comprised either of a single limiting element (16) or of a series circuit of at least two limiting elements (16).

10. Overvoltage suppressor according to claim 8, characterised in that the limiting element (15) is a Z-diode, a diode, a varistor, a VDR resistor or a further component or an arrangement with the corresponding characteristic connected to a two-port.

11. Overvoltage suppressor according to claim 1, characterised in that the switch device (18) is an electronic switch with control input (21).

12. Overvoltage suppressor according to claim 10, characterised in that the switch device (18) is an electromechanical switch with control input.

13. Overvoltage suppressor according to claim 11, characterised in that the electromechanical switch is a relay.

14. Overvoltage suppressor according to claim 1, characterised in that it includes an associated control circuit (26) for sequentially actuating the switch devices (18).

15. Overvoltage suppressor according to claim 1, characterised in that it includes an associated evaluating circuit (27) for sequentially evaluating the values provided by the current sensors (24, 25, 31) and/or the voltages across the limiting members (14).

## Revendications

1. Dispositif de protection contre les surtensions,
avec deux bornes (11, 12) d'arrivée de courant,
avec au moins deux éléments limiteurs (14) connectés en série, dont la résistance à l'état passant présente une valeur élevée en-dessous d'une tension de conduction prédéterminée et une valeur faible au-dessus de ladite tension de conduction, le circuit série (13) formé des éléments limiteurs (14) au nombre d'au moins deux étant placé entre les bornes (11, 12) d'arrivée de courant et la somme des tensions à l'état passant des éléments limiteurs (14) au nombre d'au moins deux définissant une tension maximale admissible entre les bornes (11, 12) d'arrivée de courant, la tension de conduction de chaque élément limiteur (14) isolé étant inférieure à une tension d'entrée minimale, différente de zéro, attendue aux bornes (11, 12) d'arrivée de courant et
avec, placé entre les bornes (14) d'arrivée de courant, un circuit série de moyens de commutation (18) dont le nombre correspond à celui des éléments limiteurs (14) et qui peuvent prendre chacun de manière sélective une forte ou une faible valeur ohmique chaque noeud de connexion (22) entre deux moyens de commutation (18) voisins étant connecté à un noeud de connexion (17) associé entre deux éléments limiteurs (14) par une liaison (23) électrique transversale.

2. Dispositif de protection contre les surtensions selon la revendication 1, caractérisé par le fait que chaque liaison (23) transversale contient un détecteur de courant (24, 25).

3. Dispositif de protection contre les surtensions selon la revendication 1, caractérisé par le fait que le nombre des liaisons (23) transversales est inférieure d'une unité au nombre d'éléments limiteurs (14).

4. Dispositif de protection contre les surtensions selon la revendication 1, caractérisé par le fait que chaque liaison (23) transversale est une liaison galvanique de 0 Ohm et que le circuit série des moyens de commutation (18) comporte au moins un moyen limiteur de courant (31).

5. Dispositif de protection contre les surtensions selon la revendication 4, caractérisé par le fait qu'un moyen limiteur de courant (31a) est prévu à une extrémité du circuit série des moyens de commutation (18) et qu'un moyen limiteur de courant (31b) supplémentaire est prévu à l'autre extrémité du circuit série des moyens de commutation (18).

6. Dispositif de protection contre les surtensions selon la revendication 4, caractérisé par le fait que le moyen limiteur de courant (31) comporte un détecteur de courant.

7. Dispositif de protection contre les surtensions selon la revendication 2 ou 6, caractérisé par le fait que le détecteur de courant comporte une résistance (24, 31), de préférence une résistance ohmique.

8. Dispositif de protection contre les surtensions selon la revendication 2 ou 6, caractérisé par le fait que le détecteur de courant comporte un coupleur optique (25)

9. Dispositif de protection contre les surtensions selon la revendication 1, caractérisé par le fait que chaque élément limiteur (14) est formé soit d'un élément limiteur (16) unique, soit d'un circuit série d'au moins deux éléments limiteurs (16).

10. Dispositif de protection contre les surtensions selon la revendication 8, caractérisé par le fait que l'élément limiteur (16) est une diode Zener, une diode, un varistor, un varistor au carbure de silicium ou un autre composant ou un agencement de circuit présentant des caractéristiques adaptées, connecté en dipôle.

11. Dispositif de protection contre les surtensions selon la revendication 1, caractérisé par le fait que le dispositif de commutation (18) est un commutateur électronique pourvu d'une entrée de commande (21).

12. Dispositif de protection contre les surtensions selon la revendication 1, caractérisé par le fait que le dispositif de commutation (18) est un commutateur électromécanique pourvu d'une entrée de commande.

13. Dispositif de protection contre les surtensions selon la revendication 11, caractérisé par le fait que le commutateur électromécanique est un relais.

14. Dispositif de protection contre les surtensions selon la revendication 1, caractérisé par le fait qu'un circuit de commande (26) lui est associé aux fins d'actionner tour à tour les dispositifs de commande (18).

15. Dispositif de protection contre les surtensions selon la revendication 1, caractérisé par le fait qu'un circuit de traitement (27) lui est associé aux fins de traiter successivement les valeurs délivrées par les détecteurs de courant (24, 25, 31) et/ou les tensions appliquées aux éléments limiteurs (14).
